(19) Europäisches Patentamt
European Patent Office
Office européen des brevets

(11) Veröffentlichungsnummer: **0 059 324**
**A1**

# (12) EUROPÄISCHE PATENTANMELDUNG

(21) Anmeldenummer: 82100673.1

(22) Anmeldetag: 30.01.82

(51) Int. Cl.³: C 08 F 8/42
C 08 F 8/48, H 01 B 1/12
H 01 L 29/28, H 01 L 31/02

(30) Priorität: 14.02.81 DE 3105449

(43) Veröffentlichungstag der Anmeldung:
08.09.82 Patentblatt 82/36

(84) Benannte Vertragsstaaten:
BE DE FR GB NL

(71) Anmelder: BASF Aktiengesellschaft
Carl-Bosch-Strasse 38
D-6700 Ludwigshafen(DE)

(72) Erfinder: Naarmann, Herbert, Dr.
Haardtblick 15
D-6719 Wattenheim(DE)

(72) Erfinder: Penzien, Klaus, Dr.
Bensheimer Ring 18
D-6710 Frankenthal(DE)

(72) Erfinder: Simak, Petr, Dr.
Philipp-Scheidemann-Strasse 17
D-6700 Ludwigshafen(DE)

## (54) Herstellung von elektrisch leitfähigen Polymeren und deren Verwendung in der Elektrotechnik und als Antistatika.

(57) Die Erfindung betrifft ein Verfahren zur Herstellung von elektrisch leitfähigen Polymeren mit elektrischen Leitfähigkeiten größer als $10^{-2}$ S/cm, wobei Polymerisate des Methylvinylketons mit einem Dehydratisierungsmittel zu Polymeren dehydratisiert und anschließend mit einer Lewis-Säure umgesetzt werden. Das Dehydratisierungsmittel ist bevorzugt Phosphorpentoxid, Kaliumbisulfat, Phosphorsäure, Aluminium-, Magnesium-, Eisen, Zinn- oder Anti- monoxid, die Lewis-Säure ein Halogenderivat von Elementen der III., IV., V., VI., VII. oder VIII. Gruppe des Periodensystems der Elemente.

Die erhaltenen elektrisch leitfähigen Polymeren können in der Elektrotechnik zur Herstellung von Sonnenzellen, zur Umwandlung und Fixierung von Strahlung, zur Herstellung elektrischer und magnetischer Schalter und elektrischer Speicher und zur antistatischen Ausrüstung von Kunststoffen verwendet werden.

EP 0 059 324 A1

# Herstellung von elektrisch leitfähigen Polymeren und deren Verwendung in der Elektrotechnik und als Antistatika

Die Erfindung betrifft ein Verfahren zur Herstellung von elektrisch leitfähigen Polymeren mit elektrischen Leitfähigkeiten größer als $10^{-2}$ S/cm aus Polymerisaten des Methylvinylketons und deren Verwendung in der Elektrotechnik und als Antistatika.

Bei derartigen Verfahren sind Zusätze erforderlich, um eine elektrische Leitfähigkeit bei Polymeren zu bewirken.

Es ist bekannt, elektrisch leitfähige Polymere durch oxidative Kupplung von aromatischen Verbindungen mit Hilfe von Lewis-Säuren herzustellen (vgl. "Naturwissenschaften" 56, (1969), Seite 308). Dieses Verfahren wurde jedoch nur bei aromatischen und cyloaliphatischen Systemen durchgeführt. Die erhaltenen Polymeren waren relativ niedermolekular mit Polymerisationsgraden bis zu ca. 50 und dementsprechend spröde und schwer zu verarbeiten.

Der Erfindung lag die Aufgabe zugrunde, nach einfacher chemischer Verfahrensweise elektrisch leitfähige Polymere mit Leitfähigkeiten größer als $10^{-2}$ S/cm zu schaffen, wobei von fertigen Vorpolymerisaten ausgegangen werden soll.

Die Aufgabe wurde dadurch gelöst, daß Polymerisate des Methylvinylketons mit einem Dehydratisierungsmittel zu Polymeren dehydratisiert und anschließend mit einer Lewis-Säure in Mengen von 0,1 bis 70, vorzugsweise 5 bis 45 Gewichtsprozent, bezogen auf das dehydratisierte Polymere, umgesetzt werden. Das Dehydratisierungsmittel ist bevorzugt Phosphorpentoxid, Kaliumbisulfat, Phosphorsäure, Aluminium-, Magnesium-, Eisen-, Zinn- oder Antimonoxid, die Lewis-Säure ist bevorzugt ein Halogenderivat von Elementen der III.,

Rss/P

IV., V., VI., VII. oder VIII. Gruppe des Periodensystems der Elemente. Das Polymerisat des Methylvinylketons wird bevorzugt zu dem Polymeren der allgemeinen Formel:

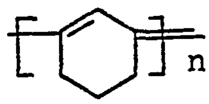 ,

wobei n = 5 bis 200, dehydratisiert.

Unter elektrisch leitfähigen Polymeren mit elektrischen Leitfähigkeiten größer als $10^{-2}$ S/cm werden Substanzen verstanden, die nach der Meßmethode von F. Beck, Berichte der Bunsengesellschaft <u>68</u>, (1964), Seite 559 eine elektrische Leitfähigkeit von über $10^{-2}$ S/cm aufweisen.

Die Polymerisate des Methylvinylketons, welche erfindungsgemäß zur Anwendung kommen, werden hergestellt nach den Angaben der Literaturstelle, Kunststoffe <u>50</u>, (1960), Seite 500. Die Herstellung der Ausgangspolymerisate ist nicht Gegenstand der Erfindung.

Nach erfindungsgemäßem Verfahren werden die bekannten Polymerisate des Methylvinylketons mit einem der Dehydratisierungsmittel Phosphorpentoxid, Kaliumbisulfat, Phosphorsäure, $Al_2O_3$, MgO, $Fe_3O_4$, $SnO_2$ oder $Sb_2O_3$ umgesetzt, wobei das dehydratisierte Polymere, das bevorzugt die Verbindung:

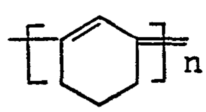 , wobei n = 5 bis 200

ist, entsteht. Hierzu kann man die Polymerisate des Methylvinylketons, die nach der oben genannten Literatur hergestellt wurden, in Gegenwart von 1 bis 30 Gewichtsprozent der obigen Metalloxid-Dehydratisiermittel 0,1 bis 5 Stunden auf 50 bis 250°C erhitzen und das erhaltene dehydratisierte Polymere mit Wasser bis zu Neutralreaktion waschen.

Das so gewonnene Polymere wird dann mit 0,1 bis 70, bevorzugt 5 bis 45 Gewichtsprozent, bezogen auf das dehydratisierte Polymere, einer Lewis-Säure versetzt. Bevorzugt wird erfindungsgemäß als Lewis-Säure ein Halogenderivat von Elementen der III., IV., V., VI., VII. oder VIII. Gruppe des Periodensystems der Elemente verwendet.

Nach besonderer bevorzugter Verfahrensweise wird als Lewis-Säure die Verbindung $AsF_5$, $SbF_5$, $UF_6$, $SbCl_5$, $AlCl_3$, $BF_3$, $FeCl_3$, $CF_3SO_3H$, $VOCl_3$, $HClO_4$, $NO^+SbF_6^-$, $NO_2^+SbF_6^-$, $NO^+AsF_6^-$, $XeF_4$, $NO^+PF_6^-$, $I_2$, $Br_2$, ICl, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $CdCl_2$ oder $BF_3/CrOCl_2$ eingesetzt.

Als Lewis-Säuren nach dem erfindungsgemäßen Verfahren kommen ferner in Frage:

Aus der <u>Gruppe VIII</u>

$KrF_2$, $XeOF_4$, $XeF_6$, $XeO_2F_2$, $HXeO_4$ sowie der

<u>Gruppe VII</u>

$ClF_3$, $ClF_5$, $BrF_3$, $IF_5$, $IF_7$, BrCl, BrI, $Cl_2O$, $Cl_2O_3$, $ClO_2$, $ClOClO_3$, $Cl_2O_6$, $Cl_2O_7$, $Br_2O$, $BrO_2$, $Br_2O_5$, $Br_3O_2$, $BrO_3$, $I_4O_5$, $I_2O_5$, HOCl, $HClO_2$, $HClO_3$, $HClO_4$, HOBr, $HBrO_2$, $HBrO_3$, $HBrO_4$, $HIO_3$, $HIO_4$, $FClO_3$, $ClF_3O$, $ClF_3O_2$, $FClO_2$, FClO, $BrO_2F$, $BrO_3F$, $IO_2F$, $IOF_3$, $IO_2F_3$, $IOF_5$ wie aus der

<u>Gruppe VI</u>

$FSO_3H$, $(FSO_3F)$, $R(SO_2F)$ mit R = NH, CH, $FXe(SO_3F)$, $FXe(OSeF_3)$, $FXe(OTeF_5)$, $Xe(OSeF_5)_4$, $Xe(OTeF_4)$, $FXe(OSeF_5)$, $F_{6-x}Cl(OSeF_5)_x$ mit x = 1 bis 5 FW $(OSeF_5)_x$ mit x = 1 bis 6,

sowie den

Nebengruppen

$AuF_5$, $PtF_6$, $IrF_6OSF_6$, $PtF_5$, $IrF_5$, $OsF_5$, $CrF_5$, $MoF_6$, $WF_5$, $MoF_5$, $VF_5$, $NbF_5$, $TaF_5$, $PuF_6$, $ReF_7$, $ReOF_5$, $CrO_2F_2$, $CrO_3$, $AuCl_3$, $PtCl_4$, $AuCl_3$.

Es kommen ferner in Frage:

Aus der
VI. Gruppe

$CF_3(CF_2)_nSO_3H$, $ClSO_3H$, $Cl_2CHSO_3H$, sowie der

V. Gruppe

$HPO_2F_2$, $P_2O_3F_4$, $BiX_3$ mit X = F, Cl, Br oder I.

IV. Gruppe

$SiF_4$, $H_2SiF_6$, $GeX_4$, $SnX_4$, $PbX_4$ mit X = F, Cl, Br der

III. Gruppe

$BX_3$, $AlX_3$, $GaX_3$, $TlX_3$ mit X = F, Cl, Br, I sowie der

Nebengruppen

$ReF_6$, $ReCl_5$, $ReCl_4$, $ReOF_4$, $VOF_3$, $NbOF_3$, $TaOF_3$, $VCl_3$, $VF_3$, $NbCl_5$, $TaCl_5$, $NbOCl_3$, $TuOCl_3$, $UCl_5$,
$CuX_2$, AgX, AuX (X = Cl, Br)
$ZnX_2$, $CdX_2$, $HgX_2$ (X = Cl, Br, I)
NiX, $PdX_2$, $PtX_2$ (X = Cl, Br, I)
$CoX_2$, $RhX_2$, $IrX_2$ (X = Cl, Br, I)

$FeX_2$, $FeX_3$, $RuX_2$, $OsX_2$ (X = Cl, Br, I)
$MnX_2$, (X = Cl, Br, I)
$TiX_4$, $ZrX_4$, $HfF_4$ (X = F, Cl, Br, I)
$SeX_3$, $Y_3X$, $LaX_3$ Lanthanide $X_3$ (X = F, Cl, Br, I)
Actinide $X_3$, $X_5$ (X = F, Cl, Br).

Die Reaktion kann mit den gasförmigen Reaktanten oder mit Hilfssäuren wie HF, $HOSeF_5$, $HOTeF_5$, $CF_3SO_3H$, $CF_3COOH$, $CF_3PO_3H$, $(CF_3)_2$, POOH, $HPF_6$, $H_2SiF_6$, $H_2PO_2F_2$, oder gegebenenfalls in inerten Lösungsmitteln wie $SO_2$, $SO_2Cl_2$, $SO_2F_2$, $SO_2ClF$, $CFCl_3$ (Frigen 11), HF, $CH_3CN$, $CH_3NO_2$, $C_2H_5NO_2$ durchgeführt werden.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter und elektrischer Schalter geeignet. Durch die Zusätze der starken Lewis-Säure entstehen sog. p-Leiter (vgl. "Journal Chemical Education", 46, (1969), Nr. 2, Seite 82).

Die in den folgenden Beispielen genannten Teile sind Gewichtsteile bzw. Molprozente.

Beispiele 1 bis 10

100 Teile Polymethylvinylketon, hergestellt durch radikalische Polymerisation von Methylvinylketon in Äthanol mit Hilfe von Azodiisobutyronitril, werden mit 20 Teilen sirupöser Phosphorsäure versetzt und 3 Stunden bei 35°C zur Reaktion gebracht, anschließend wird mit Wasser gewaschen bis Neutralreaktion eingetreten ist. Das so gewonnene und getrocknete Polymere mit der Struktur entsprechend

der obigen Formel wird dann mit 10 Teilen $AsF_5$ versetzt. Hierdurch wird ein elektrisch leitfähiges Polymerisat erhalten. Werden Metalloxide als Dehydratisierungsmittel eingesetzt, so erfolgt das Dehydratisieren bei Temperaturen von 100 bis 250°C, vorzugsweise bei 150 bis 200°C. Vor dem Komplexieren werden die Metalloxid-Dehydratisiermittel durch Säure ausgewaschen. Das verbleibende organische Polymere wird dann komplexiert.

In der folgenden Tabelle werden die Eigenschaften der erfindungsgemäß hergestellten Polymeren zusammengefaßt.

| Nr. | Dehydratisierungsmittel [Gew.%] | Komplexierungsmittel [Gew.%] | elektrische Leitfähigkeit [S/cm] |
|---|---|---|---|
| 1 | 20 $H_3PO_4$ | 10 $AsF_5$ | $6,6 \cdot 10^{-2}$ |
| 2 | 20 $H_3PO_4$ | 20 $AsF_5$ | $3,4 \cdot 10^{-2}$ |
| 3 | 20 $H_3PO_4$ | 30 $AsF_5$ | $0,9 \cdot 10^{-2}$ |
| 4 | 30 $KHSO_4$ | 20 $SbF_5$ | $3,6 \cdot 10^{-2}$ |
| 5 | 20 MgO | 25 $HClO_4$ | $5,6 \cdot 10^{-1}$ |
| 6 | 30 $P_2O_5$ | 45 $I_2$ | $0,5 \cdot 10^{-1}$ |
| 7 | 20 $Fe_3O_4$ | 25 $FeCl_3$ | $7,0 \cdot 10^{-2}$ |
| 8 | 20 $Sb_2O_3$ | 25 $BF_3$/10$CrOCl_2$ | $3,6 \cdot 10^{-1}$ |
| 9 | 20 $SnO_2$ | 25 $XeF_4$ | $1,5 \cdot 10^{-1}$ |
| 10 | 20 $Al_2O_3$ | 25 $NbF_5$ | $0,6 \cdot 10^{-1}$ |

Patentansprüche

1. Verfahren zur Herstellung von elektrisch leitfähigen Polymeren mit elektrischen Leitfähigkeiten größer als $10^{-2}$ S/cm aus Polymerisaten des Methylvinylketons, dadurch gekennzeichnet, daß Polymerisate des Methylvinylketons mit einem Dehydratisierungsmittel zu Polymeren dehydratisiert und anschließend mit einer Lewis-Säure in Mengen von 0,1 bis 70 Gewichtsprozent, bezogen auf das dehydratisierte Polymere, umgesetzt werden.

2. Verfahren nach Anspruch 1, dadurch gekennzeichnet, daß das Dehydratisierungsmittel Phosphorpentoxid, Kaliumbisulfat, Phosphorsäure, Aluminium-, Magnesium-, Eisen-, Zinn- oder Antimonoxid ist.

3. Verfahren nach Anspruch 1, dadurch gekennzeichnet, daß das Polymerisat des Methylvinylketons zu dem Polymeren der allgemeinen Formel

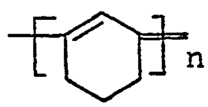 ,

wobei n = 5 bis 200, dehydratisiert wird.

4. Verfahren nach Anspruch 1, dadurch gekennzeichnet, daß die Lewis-Säure ein Halogenderivat von Elementen der III., IV., V., VI., VII. oder VIII. Gruppe des Periodensystems der Elemente ist.

5. Verfahren nach Anspruch 1, dadurch gekennzeichnet, daß mit einer Lewis-Säure in Mengen von 5 bis 45 Gewichtsprozent, bezogen auf das Polymere, umgesetzt wird.

6. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter und elektrischer Speicher.

7. Verwendung der nach Anspruch 1 hergestellten elektrisch leitfähigen Polymeren zur antistatischen Ausrüstung von Kunststoffen.

Europäisches Patentamt

# EUROPÄISCHER RECHERCHENBERICHT

0059324

Nummer der Anmeldung

EP 82 10 0673

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
| X | DE-B-1 214 402 (BASF)<br>* Anspruch; Spalte 1, Zeile 30 - Spalte 3, Zeile 13; Spalte 4, Zeilen 45-61; Beispiel 1 *<br>----- | 1-5 | C 08 F 8/42<br>C 08 F 8/48<br>H 01 B 1/12<br>H 01 L 29/28<br>H 01 L 31/02 |
| | | | RECHERCHIERTE SACHGEBIETE (Int. Cl. 3) |
| | | | C 08 F 8/42<br>C 08 F 8/48<br>H 01 B 1/12<br>H 01 L 29/28<br>H 01 L 31/02 |

Der vorliegende Recherchenbericht wurde für alle Patentansprüche erstellt.

| Recherchenort | Abschlußdatum der Recherche | Prüfer |
|---|---|---|
| DEN HAAG | 18-06-1982 | PERMENTIER W.A. |

KATEGORIE DER GENANNTEN DOKUMENTEN
- X : von besonderer Bedeutung allein betrachtet
- Y : von besonderer Bedeutung in Verbindung mit einer anderen Veröffentlichung derselben Kategorie
- A : technologischer Hintergrund
- O : nichtschriftliche Offenbarung
- P : Zwischenliteratur
- T : der Erfindung zugrunde liegende Theorien oder Grundsätze

- E : älteres Patentdokument, das jedoch erst am oder nach dem Anmeldedatum veröffentlicht worden ist
- D : in der Anmeldung angeführtes Dokument
- L : aus andern Gründen angeführtes Dokument

- & : Mitglied der gleichen Patentfamilie, übereinstimmendes Dokument